# EUROPEAN PATENT APPLICATION

(11) **EP 2 448 391 A2**
(43) Date of publication of application: **02.05.2012**
(21) Application number: 11185861.9
(22) Date of filing: 20.10.2011
(51) Int. Cl.: H05K 13/00

(54) **Positioning device for inserting pin into PCB, method and apparatus for inserting pin into PCB**

(30) Priority: 28.10.2010 CN 201010527418
(71) Applicant: Tyco Electronics (Shanghai) Co., Ltd., Waigaoqiao Free Trade Zone Shanghai (CN)
(72) Inventor: Guo, Youru, Shanghai (CN); Zhang, Hao, Shanghai (CN)
(74) Representative: Grünecker, Kinkeldey, Stockmair & Schwanhäusser

(57) **Abstract**

A positioning device (100) is provided for inserting a pin into a PCB and has an X-Y platform (11), a PCB (10) to be inserted being located on the X-Y platform (11) and provided with at least one first insertion hole (1), and the X-Y platform (11) being provided with a positioning point (2); and a reference platform (21), a reference template (20) being located on the reference platform (21) and provided with at least one reference point (3) corresponding to the at least first insertion hole (1). The X-Y platform (11) has an x-axis guide rail (30) and a y-axis guide rail (40) so that the positioning point (2) on the X-Y platform is adapted to be moved with respect to the reference template (20) in at least one of an x-axis direction and a y-axis direction to be right above each of the at least one reference point (3) on the reference template (20). When the positioning point (2) is moved to a position right above one reference point (3), one corresponding first insertion hole (1) on the PCB (10) to be inserted is located right above a fixed insertion point (4) for a pin insertion machine. A method and apparatus are also provided for inserting a pin into a PCB.

## Description

### CROSS-REFERENCE TO RELATED APPLICATION

This application claims the benefit of Chinese Patent Application No. 201010527418.X filed on October 28, 2010 in China, the entire disclosure of which is incorporated herein by reference.

### FIELD OF INVENTION

The present invention relates generally to pin insertion into a PCB, particularly, to a positioning device for inserting a pin into a PCB, and method and apparatus for inserting a pin into a PCB at a fixed insertion point by using a pin insertion machine.

### DESCRIPTION OF THE RELATED ART

In the prior art, during inserting a pin into a printed circuit board (PCB) by using a pin insertion machine, a servo motor or a stepping motor is typically used to drive an X-Y platform, on which the PCB is arranged, so as to position the PCB in a proper location. Pins are then inserted into holes formed in the PCB by the pin insertion machine.

In order to position the PCB, a complicated control system is employed to control the servo motor or the stepping motor, which in turn moves the X-Y platform with the PCB mounted thereon to position the PCB. Such a method of positioning the PCB is complicated and causes high cost.

### SUMMARY OF INVENTION

The present invention is provided to overcome or alleviate at least one aspect of the above mentioned disadvantages.

The embodiments described below disclose a positioning device for use with a pin insertion machine for inserting a pin into a PCB. The positioning device can comprise an X-Y platform for supporting a PCB to be inserted. The X-Y platform has a positioning point. The positioning device also comprises a reference platform for supporting a reference template. The X-Y platform and the reference platform are joined with each other through an x-axis guide rail and a y-axis guide rail. The positioning point on the X-Y platform is moveable relative to the reference platform in at least one of an x-axis direction and a y-axis direction, so as to align at least one first insertion holes on the PCB with a fixed insertion point of a pin insertion machine.

According to one aspect of present invention, a positioning device for inserting a pin into a PCB comprises: an X-Y platform, a PCB to be inserted being located on the X-Y platform and provided with at least one first insertion hole, and the X-Y platform being provided with a positioning point; and a reference platform, a reference template being located on the reference platform and provided with at least one reference point corresponding to the at least first insertion hole respectively. The X-Y platform comprises an x-axis guide rail and a y-axis guide rail so that the positioning point on the X-Y platform is adapted to be moved with respect to the reference template in an x-axis direction and/or a y-axis direction to be aligned with the at least one reference point on the reference template. When the positioning point is moved to a position aligned with one reference point, one corresponding first insertion hole on the PCB to be inserted is aligned with a fixed insertion point for a pin insertion machine.

In one example of the positioning device, the reference template is a reference PCB whose structure is the same as that of the PCB to be inserted and which includes at least one second insertion hole each forming one reference point.

In another example, the X-Y platform is provided with a positioning member having an elongated element, wherein a tip end of the elongated member is adapted to be extended into the second insertion hole on the reference PCB, and the tip end of the elongated member is formed as the positioning point.

In the above positioning device, the positioning device further comprises a positioning reference point, wherein the PCB to be inserted is located in a plane defined by a first plane right-angle coordinate whose coordinate origin is the fixed insertion point; and the reference PCB is located in a plane defined by a second plane right-angle coordinate whose coordinate origin is the positioning reference point, the x-axis of the second plane right-angle coordinate is in parallel with or coincides with the x-axis of the first plane right-angle coordinate, and an initial position of the positioning point is aligned with the positioning reference point. For example, the initial position of the positioning point is right above the positioning reference point.

The X-Y platform can be provided with a first fixing member for removably fixing the PCB to be inserted to the X-Y platform. The reference platform is provided with a second fixing member for removably fixing the reference PCB to the reference platform.

In the above positioning device, the X-Y platform is provided with a platform handle by means of which the X-Y platform is adapted to be moved relative to the reference platform by an operator.

According to another aspect of the present invention, a method is provided for inserting a pin into a PCB at a fixed insertion point by using a pin insertion machine. The method can comprise the following steps: (1) positioning a PCB to be inserted to an X-Y platform, wherein the PCB to be inserted is provided with at least one first insertion hole, and the X-Y platform is provided with a positioning point; (2) positioning a reference template to a reference platform, wherein the reference template is provided with at least one reference point corresponding to the at least one first insertion hole respectively; (3) moving the X-Y platform with respect to the reference platform so that the positioning point is moved to a position aligned with one reference point, and one corresponding first insertion hole on the PCB to be inserted is aligned with the fixed insertion point; (4) inserting one pin into the one first insertion hole on the PCB to be inserted aligned with the fixed insertion point by means of the pin insertion machine.

In the above method, the reference template is a reference PCB whose structure is the same as that of the PCB to be inserted and which includes at least one second insertion hole each forming one reference point.

In the above method, the X-Y platform is provided with a positioning member having an elongated element, wherein a tip end of the elongated member is adapted to be extended into the second insertion hole, and the tip end of the elongated member is formed as the positioning point, and the above step (3) further comprises the step of extending the tip end of the elongated member into the one second insertion hole, when the X-Y platform is moved with respect to the reference platform so that the positioning point is moved to the position aligned with one reference point. For example, the positioning point is moved to the position right above one reference point.

The above method can further comprise the following step: (5) after the one pin is inserted into the one first insertion hole on the PCB to be aligned with (e.g., right above) the fixed insertion point by means of the pin insertion machine, the tip end of the elongated member is retracted from the one second insertion hole.

By repeating the above steps (3)-(5), additional pins can be inserted into other corresponding first insertion holes on the PCB to be inserted.

In the above method, the X-Y platform is moved manually in the step (3).

According to still another aspect of the present invention, an apparatus for inserting a pin into a PCB is provided and comprises the above positioning device and the pin insertion machine for inserting the pin into the PCB fixed to the X-Y platform.

### BRIEF DESCRIPTION OF THE DRAWINGS

These and/or other aspects and advantages of the present invention will become apparent and more readily appreciated from the following description of the embodiments, taken in conjunction with the accompanying drawings of which:
Fig. 1 is a perspective view of the positioning device for inserting a pin into a PCB according to an exemplary embodiment of the present invention;
Fig. 2 is a plan view of the positioning device in Fig. 1;
Fig. 3 is front view of the positioning device in Fig.1;
Fig. 4 is a partially enlarged sectional view of a positioning member according to an exemplary embodiment of the present invention; and
Fig. 5 is a partially enlarged sectional view of a first fixing member according to an exemplary embodiment of the present invention.

### DETAILED DESCRIPTION OF EMBODIMENTS

Embodiments of the present invention will be described hereinafter in detail with reference to the attached drawings, wherein the like reference numerals refer to the like elements throughout the specification. These embodiments should not be construed as being limited to the embodiment set forth herein, rather for illustrative purpose.

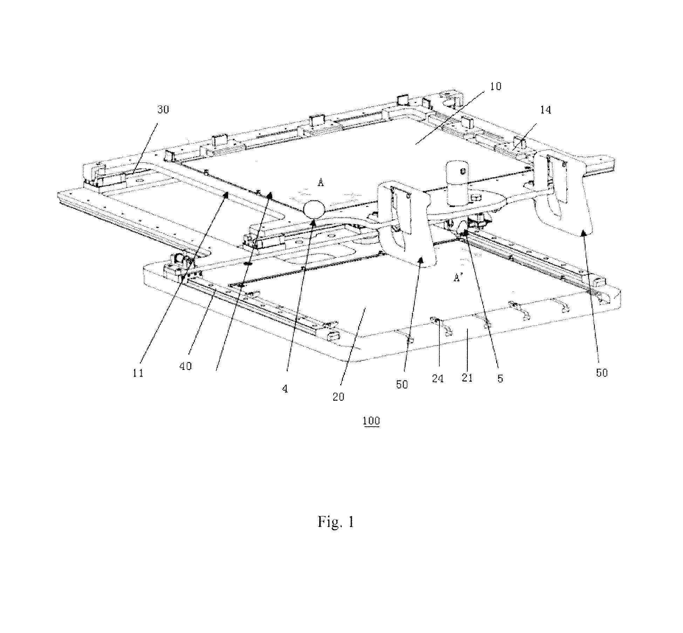

Referring to Figs. 1-3, the positioning device 100 for inserting a pin into a PCB according to an exemplary embodiment of the present invention will be described. The positioning device 100 comprises: an X-Y platform 11, a PCB 10 to be inserted being supported on the X-Y platform 11 and provided with at least one first insertion hole 1, and the X-Y platform 11 being provided with a positioning point 2; and a reference platform 21, a reference template 20 being supported on the reference platform 21 and provided with at least one reference point 3 corresponding to the at least first insertion hole 1. The X-Y platform 11 comprises an x-axis guide rail 30 and a y-axis guide rail 40 so that the positioning point 2 on the X-Y platform 11 is adapted to be moved with respect to the reference template 20 in an x-axis direction and/or a y-axis direction to be aligned with (e.g., right above) each of the at least one reference point 3 on the reference template 20. The positioning point 2 is moved to a position aligned with (e.g., right above) one reference point 3, one corresponding first insertion hole 1 on the PCB 10 to be inserted is located aligned with (e.g., right above) a fixed insertion point 4 for a pin insertion machine (not shown).

The fixed insertion point 4 herein is right below an insertion head of the pin insertion machine.

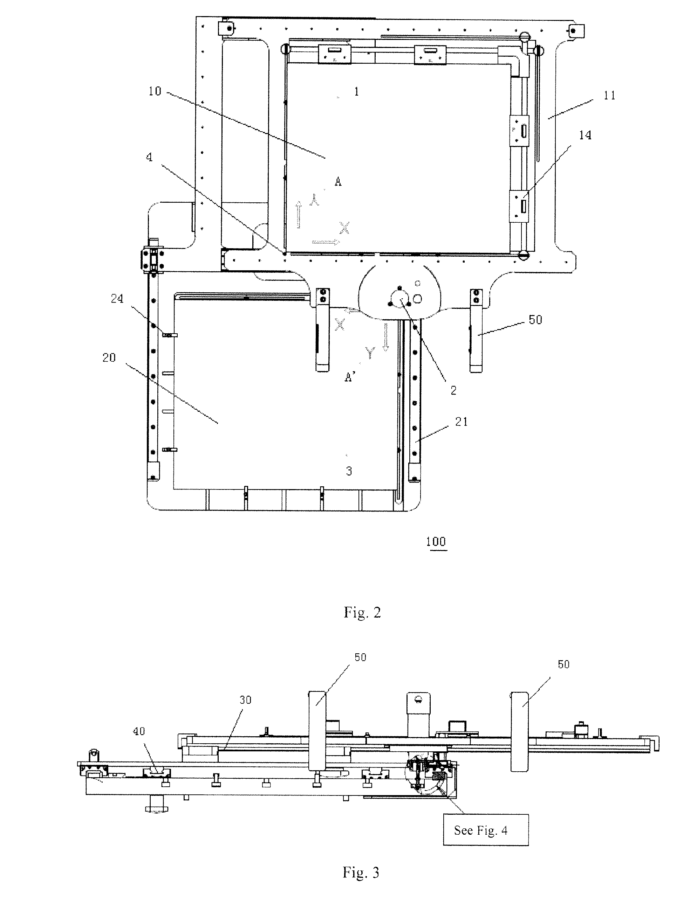

It should be noted that the relative position relation between the X-Y platform 11 and the reference platform 21 shown in Figs. 1-3 is for illustration rather than for limitation. For example, in Fig. 2, the reference platform 21 can be provided at a left side, a right side or an upper side of the X-Y platform 11, and accordingly, the position of the fixing point 2 is changed correspondingly. For example, in Fig. 2, the fixed insertion point 4 is at a bottom left corner of the PCB 10 to be inserted, and the positioning point 2 is at a top right corner of the reference template 20. In another example where the reference platform 21 is positioned at the right side of the X-Y platform 11, the positioning point 2 can be at a bottom left corner of the reference template 20. Further, the X-Y platform 11 and the reference platform 21 can be spaced from each other with a greater distance instead of being adjacent to each other as shown in Figs. 1-3. The above is only for illustration, and the X-Y platform 11 and the reference platform 21 can be arranged in other different manners based on the inventive concept of the present invention.

In addition, one skilled in the art will appreciate that the positioning point 2 can be formed integrally with the X-Y platform 11, or be directly or indirectly connected to the X-Y platform 11.

The reference template 20 herein can be formed as a plate arranged on the reference platform 21. In one example, the reference plate 20 can form the surface of the reference platform 21. On the reference plate 20 the reference point 3 can be provided, and the reference point 3 can be formed as a mark, for instance, a circular point, a recess, or a hole. For different PCBs 10 to be inserted, a different reference template 20 can be used and/or different reference points on the reference template 20 are used. Preferably, the reference point 3 has the same structure as that of the first insertion hole 1. For example, the reference point 3 can be formed as a spherical recess, a conical hole, a cylindrical hole or the like.

The reference template 20 can be a reference PCB having the same structure as that of the PCB 10 to be inserted and including at least one second insertion hole. Such second insertion hole can be used as a reference point 3. One of the PCB 10 to be inserted and reference PCB 20 can be used as the reference template (e.g., the reference template 20 can be another PCB that is the same as the PCB 10). Depending on the relative position between the X-Y platform 11 and the reference platform 21, the PCB used as the reference template can have different orientation on the reference platform 21.

The reference template 20 can be a customized template made of a metal material or other materials.

As shown in Figs. 1-3, the X-Y platform 11 is provided with a positioning member 5 having an elongated element 6. The elongated member 6 has a tip end 8 adapted to be extended into the second insertion hole (or the reference point 3) on the reference PCB 20. The tip end 8 of the elongated member 6 can be formed as the positioning point 2.

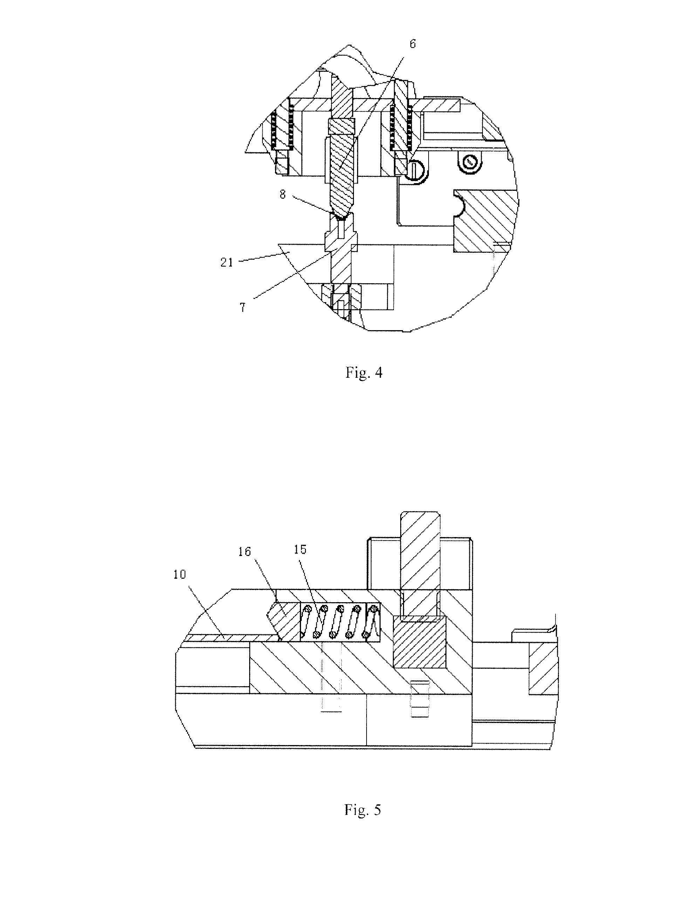

As shown in Fig. 4, the positioning device 100 further comprises a positioning reference point 7, which can be provided on the reference platform 21 or other position fixed with respect to the reference platform 21. As is shown in Fig. 2, the PCB 10 is positioned in a plane defined by a first plane of right-angle coordinate (a first XY plane) having its coordinate origin at the fixed insertion point 4. The reference PCB 20 is positioned in a plane defined by a second plane of right-angle coordinate (a second XY plane) having its coordinate origin at the positioning reference point 7. The x-axis of the second plane o fright-angle coordinate is parallel with or coincides with the x-axis of the first plane of right-angle coordinate.

The initial position of the positioning point 2 is aligned with the positioning reference point 7. For example, the initial position of the positioning point 2 is right above the positioning reference point 7. The positioning reference point 7 is positioned dependent on the relative position between the X-Y platform 11 and the reference platform 21, the position of the reference PCB 20 on the reference platform 21, the position of the PCB 10 to be inserted on the X-Y platform 11, so that the position of any point on the PCB 10 with respect to the insertion point 4 (x-axis distance and y-axis distance) corresponds to the position of a corresponding point on the reference PCB 20 with respect to the position of the positioning point 2 (x-axis distance and the y-axis distance).

For instance, in Fig. 2, the coordinates of point A on the PCB 10 are (a, b) relative to the insertion point 4 as the coordinate origin. In such as case, the coordinates of the corresponding point A' on the reference PCB 20 are also (a, b) with respect to the positioning point 2 as the coordinate origin. Thus, in Fig. 2, when the positioning point 2 on the PCB 10 is moved left by a distance a and moved downwards by a distance b to arrive at point A', point A on the PCB 10 is also moved left by a distance a and moved downwards by a distance b to arrive at the insertion point 4.

Referring to Figs. 1-2, the X-Y platform 11 is provided with a first fixing member 14 for removably fixing the PCB 10 to the X-Y platform 11. Further, the reference platform 21 is provided with a second fixing member 24 for removably fixing or retaining the reference PCB 20 on the reference platform 21. As is shown in Fig. 5, the first fixing member 14 includes a spring 15 and a locking tongue 16 biased by the spring 15. The locking tongue 16 is capable of elastically biasing the PCB 10 to fix the PCB 10 at its position. The structure of the second fixing member 24 can be different from that of the first fixing member 14.

As is shown in Fig. 1, the X-Y platform 11 is provided with a handle 50, for use by an operator to move the X-Y platform 11 relative to the reference platform 21. The handle 50 in Figs. 1-3 is only for illustration and can have other different structures. Additionally, the handle and the positioning point or the positioning member 5 can be different position relations. For example, the positioning point 2 can be provided directly to the handle 50.

A light emitting device can be provided on the insertion head of the pin insertion machine to emit a light beam towards the fixed insertion point 4. The light beam emitted is preferably a colored light beam. Thus, when the positioning point 2 is located right above the corresponding reference point 3, the light beam irradiates a first insertion hole 1 where an inserting operation is desired. The light beam helps the operator to judge whether the positioning point 2 is moved to a position right above the correct reference point.

According to another aspect of the present application, a method is provided for inserting a pin into a PCB at a fixed insertion point 4 by using a pin insertion machine. The method can comprise the following steps:

(1) positioning a PCB 10 to be inserted on an X-Y platform 11, wherein the PCB 10 to be inserted is formed with at least one first insertion hole 1, and the X-Y platform 11 is formed with a positioning point 2;

(2) positioning a reference template 20 to a reference platform 21, wherein the reference template 20 is formed with at least one reference point 3 corresponding to the at least one first insertion hole 1 respectively;

(3) moving the X-Y platform 11 relative to the reference platform 21 so that the positioning point 2 is moved to a position right above the reference point 3 on the reference template 20, and that one corresponding first insertion hole 1 on the PCB 10 is moved right above the fixed insertion point 4;

(4) inserting a pin into the first insertion hole 1 formed in the PCB 10 right above the fixed insertion point 4 by means of the pin insertion machine.

As mentioned above, the reference template 20 can be a reference PCB having the same structure as that of the PCB 10 and including at least one second insertion hole. Such second insertion hole can form one reference point 3.

The X-Y platform 11 can be provided with a positioning member 5 having an elongated element 6. The elongated member 6 can have a tip end 8 adapted to be extended into the second insertion hole and be formed as the positioning point 2. The above step (3) can further comprise extending the tip end 8 of the elongated member 6 into the second insertion hole, when the X-Y platform 11 is moved relative to the reference platform 21 so that the positioning point 2 is moved to the position right above the reference point 3. This helps to fix the position of the X-Y platform or the position of the PCB 10 on the X-Y platform during the inserting operation of the pin insertion machine.

The method further comprises step (5) of retracting the tip end 8 of the elongated member 6 from the second insertion hole, after the one pin is inserted into the first insertion hole 1 on the PCB 10 right above the fixed insertion point 4 by means of the pin insertion machine. The above steps (3)-(5) can be repeated to insert one or more pin into other corresponding first insertion hole(s) on the PCB 10 to be inserted.

According to still another aspect of the present application, an apparatus is provided for inserting a pin into a PCB. The apparatus can comprise the above described positioning device 100 and the pin insertion machine for inserting the pin into the PCB 10 fixed to the X-Y platform 11.

Although several exemplary embodiments have been shown and described, it would be appreciated by those skilled in the art that various changes or modifications can be made in these embodiments without departing from the principles and spirit of the disclosure, the scope of which is defined in the appended claims and their equivalents.

## Claims

1. A positioning device (100) for use with a pin insertion machine for inserting a pin into a PCB, the positioning device comprising:
an X-Y platform (11) for supporting a PCB (10) to be inserted, the X-Y platform (11) having a positioning point (2); and
a reference platform (21) for supporting a reference template (20);
wherein the X-Y platform (11) and the reference platform are joined with each other through an x-axis guide rail (30) and a y-axis guide rail (40), and
wherein the positioning point (2) on the X-Y platform (11) is moveable relative to the reference platform (21) in at least one of an x-axis direction and a y-axis direction, so as to align at least one first insertion holes (1) on the PCB (10) with a fixed insertion point (4) of a pin insertion machine.

2. The positioning device (100) according to claim 1 further comprising:
a PCB (10) to be inserted, which is supported on the X-Y platform (11) and formed with at least one first insertion hole (1); and
a reference template (20) supported on the reference platform (21), the reference template (20) being formed with at least one reference point (3) corresponding to the at least first insertion hole (1),
wherein, when the positioning point (2) on the X-Y platform (11) moves relative to the reference platform (21) in the at least one of an x-axis direction and a y-axis direction, the positioning point (2) aligns with the at least one reference point (3) on the reference template (20), whereby the at least one first insertion hole (1) on the PCB (10) is aligned with a fixed insertion point (4) of a pin insertion machine.

3. The positioning device (100) according to claim 2, wherein the reference template comprises a reference PCB having a same structure as that of the PCB (10) to be inserted and being formed with at least one second insertion hole, the at least one second insertion hole forming the reference point (3).

4. The positioning device (100) according to claim 3,
wherein the X-Y platform comprises a positioning member (5) having an elongated element (6),
wherein the elongated member (6) has a tip end (8) adapted to be extended into the second insertion hole in the reference PCB, and
wherein the tip end (8) of the elongated member (6) is formed as the positioning point (2).

5. The positioning device (100) according to claim 3 further comprising a positioning reference point (7),
wherein the PCB (10) to be inserted is located in a plane defined by a first plane of right-angle coordinate having a coordinate origin at the fixed insertion point (4),
wherein the reference PCB is located in a plane defined by a second plane right-angle coordinate having a coordinate origin at the positioning reference point (7),
wherein the second plane of right-angle coordinate has an x-axis parallel with or co-extending with an x-axis of the first plane of right-angle coordinate, and
wherein an initial position of the positioning point (2) is aligned with the positioning reference point (7).

6. The positioning device (100) according to claim 2, wherein the reference platform (21) comprises a fixing member (24) for removably mounting the reference template (20) to the reference platform (21).

7. The positioning device (100) according to claim 1, wherein the X-Y platform (11) is formed with a platform handle (50) for use to move the X-Y platform (11) to the reference platform (21) by an operator.

8. A method for inserting a pin into a PCB at a fixed insertion point (4) by using a pin insertion machine, the method comprising the following steps:
positioning a PCB (10) to be inserted on an X-Y platform (11), wherein the PCB (10) to be inserted is formed with at least one first insertion hole (1), and the X-Y platform (11) is provided with a positioning point (2);
positioning a reference template (20) on a reference platform (21), wherein the reference platform (21) is formed with at least one reference point (3) corresponding to the at least one first insertion hole (1);
moving the X-Y platform (11) relative to the reference platform (21) to align the positioning point (2) with the at least one reference point (3), so that the at least one first insertion hole (1) on the PCB (10) to be inserted is aligned with a fixed insertion point (4) of the pin insertion machine; and
inserting a pin into the at least one first insertion hole (1) on the PCB (10) to be inserted by means of the pin insertion machine at the fixed insertion point (4).

9. The method according to claim 8, wherein the reference template (20) is a reference PCB having a same structure as that of the PCB (10) to be inserted and including at least one second insertion hole, the at least one second insertion hole forming one reference point (3).

10. The method according to claim 9,
wherein the X-Y platform (11) is formed with a positioning member (5) having an elongated element (6), the elongated member (6) having a tip end (8) adapted to be extended into the second insertion hole and formed as the positioning point (2), and
wherein the method further comprises extending the tip end (8) of the elongated member (6) into the at least one second insertion hole, when the X-Y platform (11) is moved relative to the reference platform (21) to align the positioning point (2) with the at least one reference point (3).

11. The method according to claim 10, further comprising retracting the tip end (8) of the elongated member (6) from the at least one second insertion hole, after the pin is inserted into the at least one first insertion hole (1) on the PCB (10) to be inserted.

12. The method according to claim 8 further comprising inserting one or more other pins into one or more other corresponding first insertion holes on the PCB to be inserted.

13. The method according to claim 8, wherein the X-Y platform is moved manually.

14. An apparatus for inserting a pin into a PCB, the apparatus comprising:
the positioning device according to claim 1, and
a pin insertion machine for inserting the pin into a PCB fixed to the X-Y platform,
wherein the pin insertion machine has a fixed insertion point (4), and
whereby, when the positioning point (2) on the X-Y platform (11) is moveable relative to the reference platform (21) in at least one of an x-axis direction and a y-axis direction, the fixed insertion point (4) can be aligned with the at least one first insertion holes (1) on the PCB (10) for pin insertion.

15. The apparatus according to claim 14, wherein the reference platform (21) is immovably mounted with respect to the fixed insertion point (4).
